## Europäisches Patentamt

(19) **European Patent Office**

**Office européen des brevets**

(11) Numéro de publication: **0 138 871**

**B1**

(12) # FASCICULE DE BREVET EUROPÉEN

(45) Date de publication du fascicule du brevet:
02.09.87

(51) Int. Cl.⁴: **H 01 S 3/045**, H 01 S 3/13

(21) Numéro de dépôt: **84901083.0**

(22) Date de dépôt: **09.03.84**

(86) Numéro de dépôt international:
**PCT/FR 84/00056**

(87) Numéro de publication internationale:
**WO 84/03592 (13.09.84 Gazette 84/22)**

(54) **PROCEDE ET DISPOSITIF DE REGULATION DE LA PUISSANCE LUMINEUSE DE DIODES LASER.**

(30) Priorité: **09.03.83 FR 8303873**

(43) Date de publication de la demande:
**02.05.85 Bulletin 85/18**

(45) Mention de la délivrance du brevet:
**02.09.87 Bulletin 87/36**

(84) Etats contractants désignés:
**DE GB NL**

(56) Documents cité:
**GB-A-2 054 949**

**Patents Abstracts of Japan, vol. 5, no. 145 (E-74)(817), 12 September 1981**
**Patents Abstracts of Japan, vol. 5, no. 137 (E-72)(809), 29 August 1981**
**Patents Abstracts of Japan, vol. 6, no. 132 (E-119)(1919) 17 July 1982**
**Patents Abstracts of Japan, vol. 6, no. 132 (E-119)(1010) 17 July 1982**

(73) Titulaire: **LECOY, Pierre, 11 allée du Parc de la Bièvre, F-94240 L'Hay Les Roses (FR)**
Titulaire: **WILBROD, Jean- Hubert, 8 rue Caruel de St. Martin, F-78150 Le Chesnay (FR)**

(72) Inventeur: **LECOY, Pierre, 11 allée du Parc de la Bièvre, F-94240 L'Hay Les Roses (FR)**
Inventeur: **WILBROD, Jean- Hubert, 8 rue Caruel de St. Martin, F-78150 Le Chesnay (FR)**

(74) Mandataire: **Fort, Jacques, CABINET PLASSERAUD 84, rue d'Amsterdam, F-75009 Paris (FR)**

## Description

L'invention concerne la régulation des diodes laser devant fonctionner en régime continu et elle trouve une application importante, bien que non exclusive, dans le domaine des transmissions numériques sur fibres optiques.

On sait que les diodes laser sont largement utilisées pour la transmission sur fibres optiques, du fait notamment qu'elles sont capables de fonctionner à des fréquences beaucoup plus élevées que les diodes électroluminescentes. Mais en contrepartie, ces diodes laser ont l'inconvénient de présenter des variations importantes de la puissance lumineuse émise en réponse à une variation faible du courant par rapport à la valeur de seuil. Or, cette valeur de seuil présente des variations notables qui sont soit réversibles, en fonction de la température notamment, soit irréversibles, par suite notamment du vieillissement.

Pour pallier les effets de ces variations, il est nécessaire d'assurer une régulation de la puissance lumineuse de sortie. On connaît déjà des procédés de régulation de la puissance lumineuse émise par une diode laser fonctionnant en régime continu, suivant lesquels on compare un signal électrique représentatif de ladite puissance lumineuse à un signal électrique de référence correspondant à une puissance de consigne pour élaborer un signal d'erreur, et on modifie automatiquement les conditions de fonctionnement de la diode laser en fonction dudit signal.

Habituellement, c'est le courant électrique d'alimentation de la diode laser qui est commandé par une boucle de contre-réaction dont la valeur d'entrée est constituée par l'écart entre la puissance lumineuse de sortie mesurée et une puissance de consigne.

Il est fréquemment nécessaire d'ajouter, à cet asservissement du courant, une régulation en température pour garantir une region de travail stable du laser. Un tel procédé et un tel dispositif de regulation selon les préambules des revendications 1 et 2 sont connus du jorurnal Patent Abstract o Japan Vol. 5, No 145, Sept. 1981, E- 74, 814, correspondant à JP-A- 5 678 183.

Les diodes laser actuelles doivent fonctionner à une température au plus peu supérieure aux températures ambiantes habituelles. Des températures élevées accélèrent en effet le vieillissement et accroissent le risque de destruction, alors qu'au contraire un abaissement de la température lors du fonctionnement augmente la durée de vie. Une autre raison qui rend fréquemment nécessaire une régulation en température est la nécessité d'évacuer la chaleur dégagée à la jonction de la diode laser. Cette régulation en température est généralement effectuée par refroidissement à l'aide d'un élément actif, tel qu'un élément à effet Peltier, commandé par une seconde boucle de contre-réaction dont le signal d'entrée est constitué par l'écart entre la température mesurée du laser et la température de consigne, voir par exemple Patent Abstract of Japan, Vol. 6, No. 132, July 1982, (E- 119) (1010) correspondant à JP-A- 5 756 983.

Diverses raisons, qui seront exposées en détail plus loin, font que cette solution est peu satisfaisante. En particulier, cette double régulation nécessite un nombre de composants important et elle souffre d'un défaut dans son principe même: pour maintenir la puissance lumineuse émise, au cours du vieillissement, on est conduit à augmenter le courant d'alimentation, ce qui provoque une augmentation de l'échauffement et de la puissance consommée par l'élément à effet Peltier, d'où augmentation de la puissance consommée globale. De plus, il est difficile de mesurer la température de la jonction de la diode laser, de sorte que la température mesurée est celle de l'embase de la diode, sur laquelle est fixée une thermistance. La différence de température qui existe entre l'embase et la jonction va augmenter au fur et à mesure des augmentations du courant électrique au cours du vieillissement, de sorte que, à température de consigne donnée, la température de la jonction augmente, ce qui accélére encore le vieillissement.

L'invention vise à fournir un procédé et un dispositif répondant mieux que ceux antérieurement connus aux exigences de la pratique, notamment par leur simplicité et le fait qu'ils éliminent les phénomènes de réaction positive mentionnés ci-dessus.

Dans ce but, l'invention utilise le fait que le courant de seuil d'une diode laser augmente avec la température suivant une loi qui est approximativement exponentielle, et elle prévoit un procédé du genre défini dans le préambule de la revendication 1, caractérisé en ce qu'on commande le débit thermique extrait de la diode laser de façon à annuler le signal d'erreur tout en alimentant la diode laser à courant électrique constant.

L'invention consiste également en un dispositif de régulation permettant de mettre en oeuvre le procédé ci-déssus défini. Ce dispositif comprend un photodétecteur disposé de façon à fournir un signal électrique représentatif de la puissance lumieneuse moyenne de la diode laser et un circuit associé au photodétecteur pour fournir un signal d'erreur représentatif de l'écart entre la puissance lumineuse moyenne et une puissance de consigne, ainsi qu'un circuit de commande des moyens de refroidissement du laser recevant le signal d'erreur. Il se caractérise en ce que le circuit de commande est monté de façon à commander le refroidissement dans un sens tendant à annuler le signal d'erreur et en ce que ledit circuit d'alimentation est à courant constant.

Un tel dispositif, extrêmement simple, donne des résultats entièrement satisfaisants lorsque l'environnement de la diode laser ne présente pas d'à-coups thermiques brutaux, ce qui est par exemple le cas dans un répéteur de câbles sous- marins. Lorsque l'environnement est susceptible au contraire de présenter des variations de température de rapidité incompatible avec la constante de temps importante du dispositif tel que défini plus haut, constante de temps fixée notamment par l'inertie thermique des éléments, le dispositif est avantageusement complété par adjonction d'une branche d'asservissement agissant sur le courant d'alimentation de la diode laser, lorsque la différence entre la puissance lumineuse fournie par la diode laser et la puissance de consigne dépasse un seuil prédéterminé. Mais il est essentiel de garder en mémoire que cette branche n'a qu'un rôle accessoire et n'intervient que de façon transitoire, pendant le délai nécessaire pour que la régulation thermique ait compensé l'effet de la variation de température ou en cas de défaillance du dispositif principal.

L'invention sera mieux comprise à la lecture de la description qui suit de modes particuliers de réalisation donnés à titre d'exemples, et de la comparaison qui en est faite avec l'art antérieur. La description se réfère aux dessins qui l'accompagnent, dans lesquels:

- la Figure 1 est un schéma montrant un dispositif classique de régulation de la puissance lumineuse d'une diode laser;
- la Figure 2 montre la variation de la puissance lumineuse P d'une diode laser en fonction du courant 1, pour deux températures T1 et T2, T2 étant supérieure à T1.
- la Figure 3, similaire à la Figure 1, montre un dispositif qui constitue un mode particulièrement simple de mise en oeuvre de l'invention;
- les Figures 4 et 5 sont des courbes montrant, en fonction du temps t, l'écart ΔT entre la température du laser et sa température initiale et l'écart ΔI entre la consommation totale de courant et la consommation initiale, pour le dispositif classique montré en Figure 1 (courbe en tirets) et pour le dispositif de la Figure 3 (courbe en trait plein);
- les Figures 6 et 7 montrent la variation de la puissance lumineuse sortie du laser en fonction du courant, respectivement dans le cas où la pente de la caractéristique de la diode laser n'est pas constante et dans le cas où cette caractéristique présente des non-linéarités violentes.
- la Figure 8, similaire aux Figures 1 et 3, montre un dispositif qui constitue un autre mode de réalisation de l'invention, qui se différencie de celui de la Figure 3 en ce qu'il comporte un asservissement supplémentaire de sécurisation;
- la Figure 9 montre la fonction de transfert $v_s(v_e)$ du quadripôle 36 du dispositif de la Figure 8;
- les Figures 10 sont des courbes destinées à faire apparaître la fonction de l'asservissement de sécurisation de la Figure 8 lors d'une variation rapide de la température extérieure;
- les Figures 11, font apparaître l'intervention de l'asservissement de sécurisation en cas de défaillance du dispositif de régulation principal;

- les Figures 12 et 13 sont des schémas de détail montrant des variantes de la Figure 8.

Avant de décrire l'invention, on rappellera brièvement la constitution type des dispositifs classiques de régulation de la puissance lumineuse d'une diode laser par variation de courant.

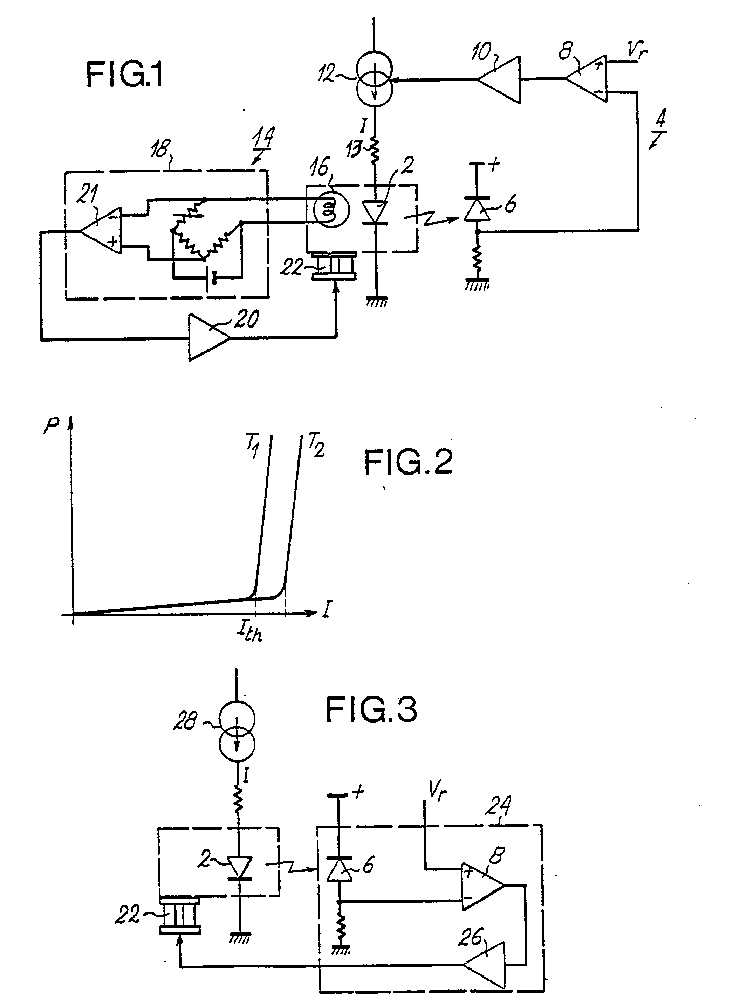

Le dispositif de ce type montré en Figure 1 est destiné à maintenir à une valeur constante la puissance lumineuse émise par une diode laser 2. Pour cela, le dispositif comprend une boucle de contre-réaction 4 qui comprend une photodiode 6 fournissant un signal électrique proportionnel à la puissance lumineuse émise par le laser. Pour cela, la photodiode 6 peut être placée par exemple de façon à recueillir la lumière qui sort par la face arrière de la diode laser. Le signal électrique provenant de la diode 6 est appliqué à l'une des entrées d'un comparateur 8 dont l'autre entrée reçoit une tension de référence $V_r$ représentant la puissance lumineuse de consigne. Le signal d'erreur est ainsi proportionnel à la différence entre la puissance effectivement émise et la puissance de consigne. Un amplificateur 10 porte ce signal à un niveau convenable pour commander une source de courant 12, afin d'ajuster le courant injecté dans la diode laser par l'intermédiaire d'une résistance 13.

Comme on l'a indiqué plus haut, les dispositifs connus comportent fréquemment une boucle de régulation en température. L'élément d'entrée de la boucle de régulation en température 14 montrée en Figure 1 est constitué par un élément 16 sensible à la température, tel qu'une thermistance dont la résistance est une fonction bi-univoque de la température. Cette thermistance est souvent fixée sur l'embase du laser, et non pas sur la diode laser elle-même, du fait de la fragilité et des petites dimensions de cette dernière. Le signal de sortie de l'élément 16 attaque, par l'intermédiaire d'un dispositif comparateur 18, qui fournit un signal d'erreur lié à la différence entre la température mesurée et la température de consigne, un amplificateur 20 de gain et de constante de temps appropriés. Le signal d'erreur amplifié commande un élément refroidisseur 22 destiné à ramener la température à une valeur aussi proche que possible de la température de consigne, notamment lorsque la température extérieure ou la chaleur dégagée par le laser varie. Le dispositif 18 peut par exemple être constitué par un pont de Wheatstone et un comparateur 21.

La température de consigne, qui peut être ajustable par action sur un des éléments du pont de Wheatstone, peut être soit proche des températures ambiantes rencontrées habituellement en fonctionnement, soit notablement plus basse.

Grâce à cette disposition, on peut compenser la variation importante du courant de seuil $I_{th}$ provoquée par les variations de température de la diode laser, comme le montre la Figure 2. Mais le dispositif classique de la Figure 1 présente de nombreux inconvénients. Il comprend un nombre d'éléments élevé. Et, surtout, la boucle de régulation en température souffre d'un défaut de principe fondamental. La température asservie est celle de l'embase de la diode laser 2, dont la température présente, avec celle de la diode laser, une différence qui est de l'ordre de 25 à 40°C/W dans les meilleurs cas. La température du laser excède donc toujours la température de consige d'une quantité qui, initialement de quelques degrés, va se trouver modifiée du fait d'un phénomène de réaction psitive au cours du vieillissement. Lorsque le courant que fait passer la source 12 dans la diode laser augmente, du fait du vieillissement de cette dernière, les dégagements de chaleur augmentent et entraînent une augmentation de température qui accélère encore le vieillissement. L'élément refroidisseur, généralement constitué par un élément Peltier, a plus de chaleur à évacuer et consomme davantage de courant, ce qui accroît encore la dérive de la température du laser et de la consommation générale. Cet effet d'emballement, à long terme, risque de réduire la durée de vie de la diode laser, notamment pour celles qui sont particulièrement sensibles à la température, comme les récentes diodes laser à grande longueur d'onde.

Le dispositif conforme à l'invention montré en Figure 3 permet de remédier à ce défaut, notamment du fait qu'il utilise une information d'entrée liée à la température réelle du laser et évite tout phénomène de contre-réaction positive.

Le dispositif montré en Figure 3, où les éléments correspondant à ceux de la Figure 1 portent le même numéro de référence, ne comprend qu'une seule boucle d'asservissement 24. Cette boucle utilise, comme élément d'entrée, un capteur sensible au flux lumineux émis par la diode laser 2, par exemple une photodiode 6. Le signal émis par la photodiode, représentatif de la puissance lumineuse, est appliqué à un comparateur 8 qui reçoit également un signal de référence $V_r$ représentant la puissance lumineuse de consigne. Mais le signal de sortie du comparateur n'est plus utilisé pour commander le courant, comme dans le cas de la Figure 1, mais est utilisé pour commander la température de la diode laser. Pour cela, le signal d'erreur provenant du comparateur 8 est appliqué, par l'intermédiaire d'une chaîne amplificatrice 26, de gain et de constante de temps déterminés en fonction des caractéristiques recherchées, à l'élément refroidisseur 22. La diode laser 2 est alimentée par la source 28 qui, dans le mode de réalisation simple de la Figure 3, fournit un courant I constant.

Le dispositif montré en Figure 3 fonctionne de la façon suivante, lorsque la puissance lumineuse émise par la diode laser 2 diminue, du fait soit d'une augmentation de la température extérieure, soit du vieillissement du laser.

Un signal d'erreur apparaît à l'entrée de la chaîne amplificatrice 26. Il provoque la commande de l'élément refroidisseur 22 dans un sens qui tend à abaisser la température de la diode laser 2 jusqu'à ce que la puissance lumineuse émise soit égale à la puissance de consigne, déterminée par la tension de référence $V_r$. En effet, à un moment donné de la vie du laser et pour un courant I donné, il y a une correspondance biunivoque entre la puissance lumineuse et la température.

En d'autres termes, l'intensité du refroidissement est commandée par un paramètre représentatif de la température réelle du laser, et non pas de son embase, et elle assure la constance de la puissance lumineuse nécessaire au bon fonctionnement du système à l'aide d'une boucle de contre-réaction unique. Au cours de la vie du laser, la température de ce dernier diminue lentement, ce qui ralentit le processus de vieillissement et augmente la durée de vie. La dérive de température va dans un sens favorable et se relentit elle-même, alors que dans le cas du système classique de la Figure 1, on a une dérive qui s'accélère d'elle-même.

Les avantages du dispositif montré en Figure 1 apparaissent immédiatement: la stabilisation de la puissance optique, l'évacuation de la chaleur dégagée par le laser, la stabilisation à court terme de température sont assurées par une boucle unique, avec un nombre d'éléments constitutifs presque deux fois moindre que dans un dispositif classique. De plus, la suppression de la thermistance 16 prévue dans le dispositif de la Figure 1 autorise une conception simplifiée.

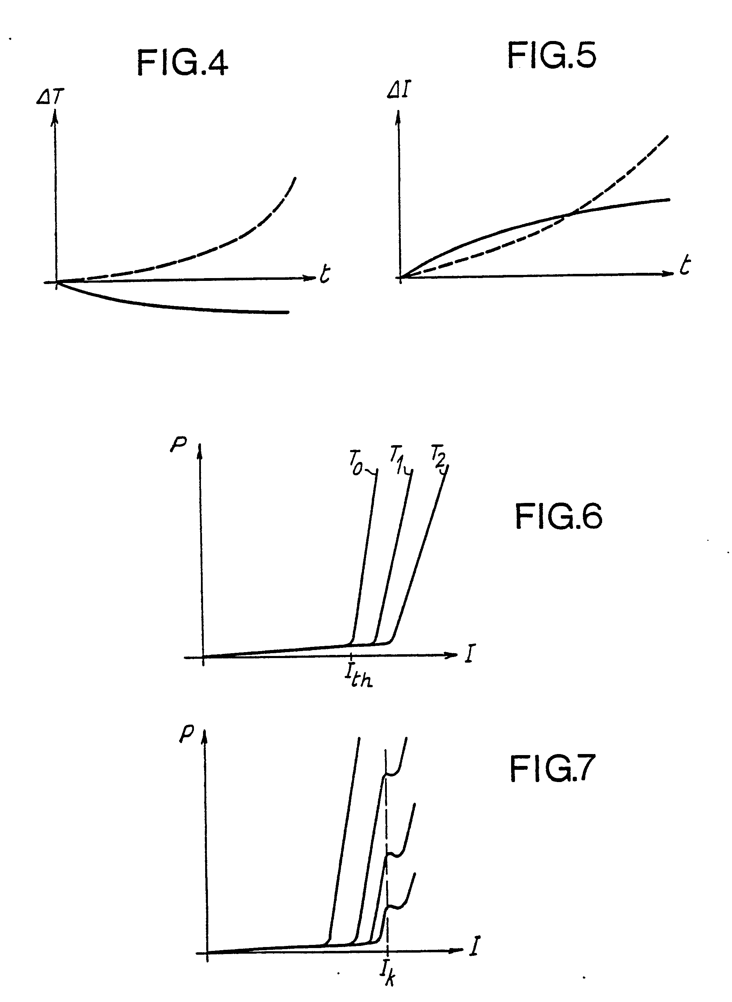

L'effet de réaction positive présenté par le dispositif de la Figure 1 disparaît et il faut noter au passage que la dérive $\Delta T$ de température en fonction du temps dans le cas d'un dispositif suivant la Figure 3 (courbe en trait plein sur la Figure 4), si elle est initialement plus rapide qu'avec le dispositif classique de la Figure 1 (courbe en tirets), se ralentit et devient plus lente à long terme. Le fait que la diode laser est alimentée par une source de courant constant simplifie la conception et diminue la consommation globale des courants à long terme: si en effet la consommation de l'élément refroidisseur à effet Peltier 22 augmente d'abord plus vite dans le cas du dispositif suivant l'invention (Figure 5), cette augmentation se ralentit ensuite, de sorte qu'au bout de peu de temps, l'augmentation globale $\Delta I$ de consommation devient moins élevée que dans le cas du dispositif classique.

De plus, le dispositif suivant l'invention permet d'atténuer, sans adjonction d'éléments supplémentaires, l'effet de caractéristiques particulières de certains types de diodes laser.

En particulier, la pente de la caractéristique (puissance lumineuse P en fonction de l'intensité du courant I) diminue pour certains lasers à semiconducteurs lorsque la température augmente ou lorsque le composant vieillit, comme le montre la Figure 6 où les courbes $T_0$, $T_1$ et $T_2$ correspondent à des températures progressivement croissantes ou à des vieillissements progressivement plus accentués. Dans un dispositif classique, il faut ajouter une boucle supplémentaire d'asservissement, dite "dynamique", agissant sur l'amplitude de modulation du signal électrique destiné à maintenir constante l'amplitude de modulation du signal optique. Or, dans de nombreux cas, une diminution de la température compense l'effet du vieillissement sur la pente de la caractéristique, comme elle le fait sur le courant de seuil $I_{th}$, ce qui peut permettre d'éviter l'adjonction d'une boucle d'asservissement dynamique. Dans d'autres cas, la diode à semiconducteur a une caractéristique P (I) qui présente de violentes non-linéarités, couramment désignées par le terme anglo-saxon de "kinks", comme le montre la Figure 7; elles apparaissent généralement pour un courant donné I. Le dispositif de la Figure 3, fonctionnant à courant constant, permet de travailler dans une zone où n'apparaissent pas de telles non-linéarités.

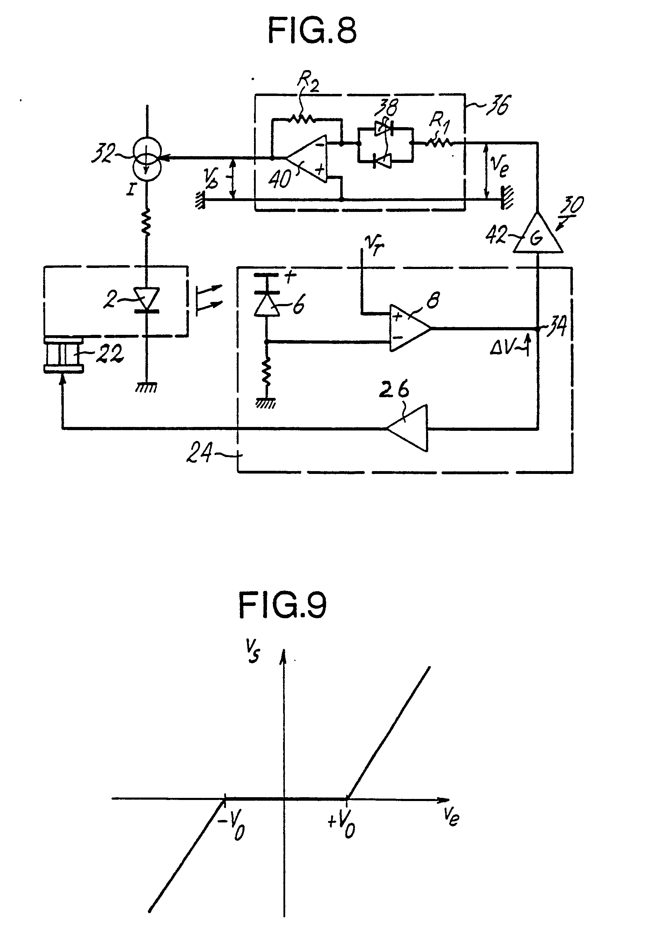

Le dispositif simple représenté en Figure 3 a un temps de réponse relativement long, pouvant atteindre plusieurs secondes, du fait de l'inertie thermique des pièces. Cette propriété est sans inconvénient dans la plupart des applications en télécommunications, où les variations de température externe sont lentes. Mais, lorsque la diode laser est susceptible d'être exposée à des variations brutales de la température externe ou lorsqu'on veut maintenir approximativement la puissance optique en cas de défaillance de la boucle 24 pendant le temps nécessaire à une intervention, on peut adopter le dispositif montré en Figure 8. Ce dispositif comprend, en plus des éléments déjà montrés en Figure 3, une branche supplémentaire 30 que l'on peut qualifier de branche de "sécurisation". La branche 30 agit sur la source 32 alimentant la diode laser pour régler le courant I fourni. La branche 30 utilise, comme signal d'entrée, la tension $\Delta V$ au point 34, à la sortie du comparateur 8. Cette tension $\Delta V$ est une fonction croissante de la différence entre la puissance effective P émise et la puissance de consigne et elle s'annule avec elle. La branche 30 est prévue pour commander la source 32 de façon à modifier le courant I uniquement lorsque la valeur absolue $|\Delta V|$ de $|\Delta V|$ dépasse un seuil prédéterminé $V_0$, c'est-à-dire lorsque la différence entre la puissance lumineuse fournie par la diode laser et la puissance de consigne $|\Delta P|$ dépasse un seuil $\Delta P_0$ déterminé.

La branche 30 n'intervient donc qu'en cas de transitoire rapide, ou de venue en butée de la régulation assurée par la boucle 24 à cause de conditions de température extrêmes, ou enfin en cas de défaillance de l'élément refroidisseur 22 ou des circuits qui le commandent. En régime normal permanent, $|\Delta P|$ est inférieure à $\Delta P_0$ et la chaîne d'asservissement 30 ne fonctionne pas: la diode laser est alimentée, comme dans le cas de la Figure 3, à courant I constant.

Pour réaliser cette action conditionnelle, la branche de sécurisation 30 peut par exemple comporter un quadripôle 36 dans lequel le seuil est obtenu par un pont de diodes semiconductrices 38, montées tête-bêche, ayant une tension de seuil $V_0$. L'une des bornes du pont 38 est reliée à l'entrée du quadripôle par une résistance $R_1$. L'autre borne est reliée à l'entrée inverseuse d'un amplificateur opérationnel 40 dont l'entrée non-inverseuse est reliée à la masse.

De cette façon, un courant n'est appliqué à l'amplificateur opérationnel 40 que si la valeur absolue $|v_e|$ de la tension d'entrée est supérieure à $V_0$.

Une résistance de contre-réaction $R_2$ est placée entre l'entrée inverseuse et la sortie de l'amplificateur opérationnel 40, qui constitue également la sortie du quadripôle.

La fonction de transfert $v_s$ ($v_e$) du quadripôle 36 est du genre montré en figure 9, où on voit apparaître l'effet de seuil. La pente des parties de la caractéristique correspondant à l'intervention du quadripôle est fixée par $R_2/R_1$.

La branche de sécurisation 30 tend à ramener $v_s$ à une valeur nulle. Elle ramène la puissance optique P non pas à la valeur de consigne $P_0$, mais à une valeur $P_0 \pm \Delta P$, suivant le sens de dépassement du seuil. Le rapport $\Delta P/P_0$ peut être fixé à volonté: en effet, il correspond à $V_0/G.V_r$, G étant le gain d'un amplificateur à courant continu 42 placé en amont du quadripôle 36. On peut ainsi donner à $_\Delta P$ une valeur faible par rapport à $P_0$. Cette réduction de $_\Delta P$ n'est d'ailleurs pas forcément nécessaire, lorsqu'on cherche uniquement à absorber les régimes transitoires. En effet, l'asservissement principal continue à agir, avec une constante de temps longue, du fait du signal d'erreur lié à $_\Delta P$ et qui n'est donc pas nul. Par action sur la température, la boucle 24 d'asservissement principale ramène progressivement la puissance lumineuse P à la valeur de consigne $P_0$, mettant fin à l'action de la branche d'asservissement de sécurisation 36.

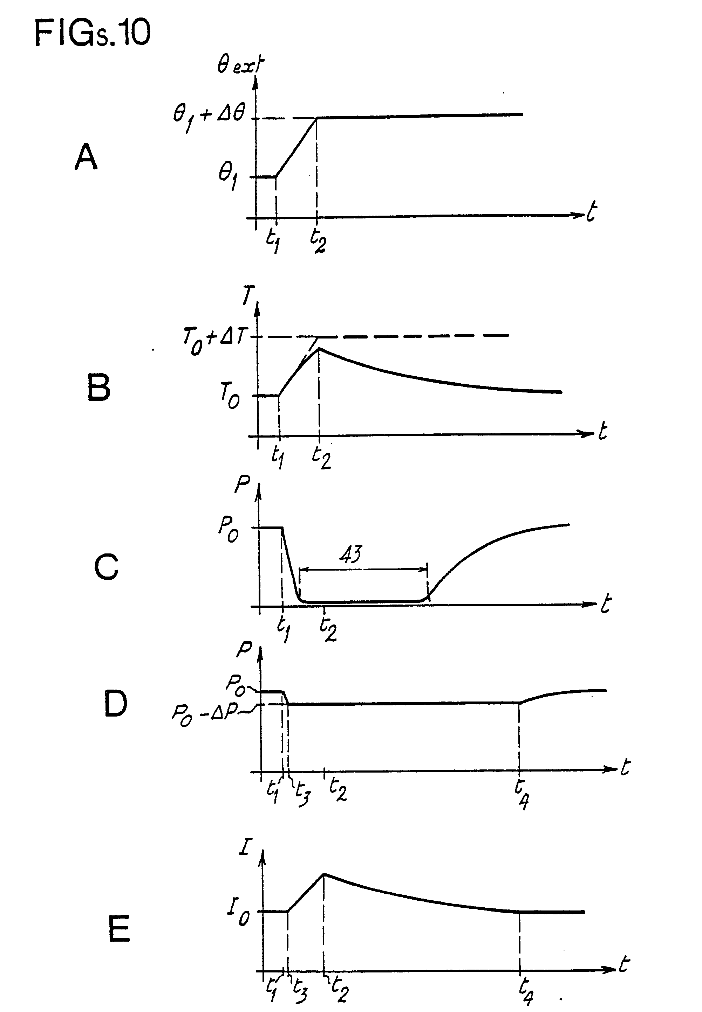

Les Figures 10A à 10E montrent la différence de réponse entre le dispositif de la Figure 3 et celui de la Figure 8 en cas de variation rapide de la température extérieure $\theta$ qui passe de $\theta_1$ à $\theta_1 + \Delta\theta$ dans un intervalle de temps bref $t_2 - t_1$ (Figure 10A). La variation de la température T du laser va alors, dans les deux cas, avoir l'allure montrée en Figure 10B, la baisse de température étant lente du fait de la constante de temps thermique. Dans le cas du dispositif simple de la Figure 3, il peut y avoir interruption momentanée de l'émission pendant un intervalle de temps 43 (Figure 10C). Dans le cas d'un dispositif comprenant une branche de sécurisation, cette dernière intervient dès que la puissance optique est tombée à la valeur $P_0 - _\Delta P$ pour la maintenir à cette dernière valeur (Figure 10D). La branche 30 intervient donc de l'instant $t_3$ jusqu'à l'instant $t_4$ où la régulation de température a permis de ramener la puissance optique au-dessus de $P_0 - _\Delta P$. Le courant I fourni à la diode ne s'écarte de la valeur constante $I_0$ que pendant l'intervalle de temps allant de $t_3$ à $t_4$ (Figure 10E).

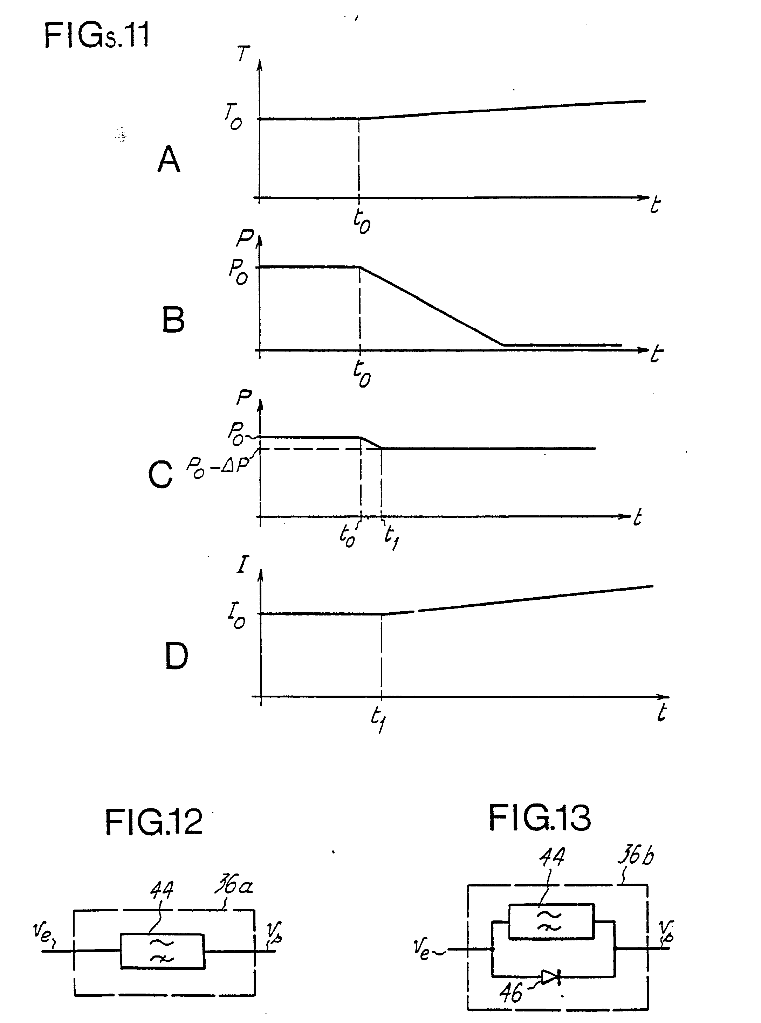

Dans le cas d'une panne du système de refroidissement, la branche de sécurisation 30 intervient pour empêcher la puissance optique du laser de descendre au-dessous de la valeur $P_0 - _\Delta P$, comme indiqué sur les Figures 11A à 11D. La Figure 11A montre l'augmentation progressive de la température à partir de l'instant $t_0$ de la panne. En l'absence de sécurisation, la puissance lumineuse P va s'annuler rapidement (Figure 11B). Au contraire, dans le cas où est prévue la branche de sécurisation 30, cette dernière stabilise la puissance, lumineuse à la valeur $P_{0-\Delta}P$ (Figure 11C), ce qui maintient la transmission par modification du courant I qui traverse le laser, en attendant une intervention (Figure 11D). Des moyens peuvent être prévus pour déceler la présence permanente d'un signal d'erreur non nul au point 34 et déclencher une alarme.

L'invention est susceptible de nombreuses autres variantes encore de réalisation. En particulier, la branche de sécurisation peut être réalisée de façon différente de celle illustrée, de façon à maintenir la séparation entre le régime permanent, pendant lequel seule fonctionne la boucle-d'asservissement principale, du régime transitoire, pendant lequel la branche de sécurisation intervient en secours.

A titre d'exemples, les Figures 12 et 13 montrent des circuits 36a et 36b pouvant être utilisés en remplacement du quadripôle 36 de la Figure 8. Au lieu de réaliser une fonction de transfert non linéaire, les circuits 36a et 36b comportent un filtre passe-haut 44 destiné à isoler les composantes transitoires du signal d'erreur prélevé en 34 (Figure 8). Dans le cas montré en Figure 13, une diode à seuil 46 est placée en parallèle avec le filtre 44 pour prendre le relais de l'asservissement principal en cas de défaillance de l'élément refroidisseur.

## Revendications

1. Procédé de régulation de la puissance lumineuse émise par une diode laser fonctionnant en régime continu, suivant lequel on compare un signal électrique représentatif de ladite puissance lumineuse à un signal électrique de référence correspondant à une puissance de consigne pour élaborer un signal d'erreur, et on modifie automatiquement les conditions de fonctionnement de la diode laser en fonction dudit signal, caractérisé en ce qu'on commande le débit thermique extrait de la diode laser de façon à annuler le signal d'erreur tout en alimentant la diode laser à courant électrique constant.

2. Dispositif de régulation de la puissance lumineuse émise par une diode laser fonctionnant en régime continu et associée à un circuit d'alimentation électrique, comprenant un photodétecteur (6) disposé de façon à fournir un signal électrique représentatif de la puissance lumineuse moyenne de la diode laser et un circuit associé au photodétecteur pour fournir un signal d'erreur représentatif de l'écart entre la puissance lumineuse moyenne et une puissance de consigne, ainsi qu'un circuit de commande de moyens de refroidissement du laser recevant le signal d'erreur caractérisé en ce que ledit circuit de commande est monté de façon à commander le refroidissement dans un sens tendant à annuler le signal d'erreur et en ce que ledit circuit d'alimentation (12, 32) est à courant constant en régime continu.

3. Dispositif selon la revendication 2, caractérisé en ce qu'il comprend, de plus, une branche d'"asservissement (36a, 36b) commandant le circuit d'alimentation (32) lorsque la différence entre la puissance lumineuse fournie par la diode laser (2) et la puissance de consigne dépasse un seuil prédéterminé.

4. Dispositif selon la revendication 2, caractérisé en ce qu'il comprend, de plus, une branche d'asservissement (30) commandant le circuit d'alimentation (32) en réponse aux variations rapides de la puissance optique de sortie du laser.

5. Dispositif selon la revendication 3 ou 4, caractérisé en ce que ladite branche d'asservissement comporte une entrée reliée à la sortie du circuit (8) associé au photodétecteur et comprend un amplificateur opérationnel précédé d'un élément à seuil (38) et/ou d'un filtre passe-haut (44).

## Patentansprüche

1. Verfahren zum Regeln der von einer in einem stetigen Bereich arbeitenden Laserdiode abgegebenen Lichtleistung, wobei ein elektrisches, für die Lichtleistung repräsentatives Signal mit einem elektrischen Referenzsignal, welches einer Vorgabeleistung entspricht, zum Zwecke der Ermittlung eines Fehlersignals verglichen wird, und wobei die Funktionsbedingungen der Laserdiode automatisch in Abhängigkeit von diesem Signal verändert werden, dadurch gekennzeichnet, daß die von der Laserdiode ausgegebene technische Ausgangsleistung derart gesteuert wird, daß das Fehlersignal zum Verschwinden gebracht wird, indem die Laserdiode immer mit einer konstanten elektrischon Stromstärke versorgt wird.

2. Einrichtung zum Regeln der von einer in einem stetigen Bereich arbeitenden, an einem elektrischen Versorgungsstromkreis angeschlossenen Laserdiode abgegebenen Lichtleistung, umfassend einen Photodetektor (6), der so ausgelegt ist, daß er ein für die mittlere Lichtleistung der Laserdiode repräsentatives elektrisches Signal erzeugt, ferner einen dem Photodetektor zugeordneten Stromkreis, welcher ein für die Abweichung zwischen der mittleren Lichtstärke und einer Vorgabeleistung repräsentatives Fehlersignal erzeugt, sowie ferner einen das Fehlersignal empfangenden Steuerkreis zum Steuern von Mitteln zum Kühlen des Lasers, dadurch gekennzeichnet, daß der Steuerkreis so ausgelegt ist, daß er die Kühlung im Sinne eines Verschwindens des Fehlersignals steuert und daß der Versorgungsstromkreis (12, 32) eine konstante Stromstärke in einem stetigen Bereich aufweist.

3. Einrichtung nach Anspruch 2, dadurch gekennzeichnet, daß sie zusätzlich einen Regelkreis (36a, 36b) umfaßt, welcher den Versorgungsstromkreis (32) steuert, wenn die Differenz zwischen der von der Laserdiode (2) erzeugten Lichtleistung und der Vorgabeleistung eine vorgegebene Schwelle überschreitet.

4. Einrichtung nach Anspruch 2, dadurch gekennzeichnet, daß sie zusätzlich einen Regelkreis (30) umfaßt, welcher den Versorgungsstromkreis (32) in Abhängigkeit von schnellen Änderungen der optischen Ausgangsleistung des Lasers steuert.

5. Einrichtung nach Anspruch 3 oder 4, dadurch gekennzeichnet, daß dieser Regelkreis einen Eingang aufweist, welcher mit dem Ausgang des dem Photodetektor zugeordneten Stromkreises (8) verbunden ist, und daß er einen Operationsverstärker umfaßt, dem ein Schwellenspannungselement (38) und/oder ein Hochpass-Filter (44) vorgeschaltet ist.

**Claims**

A process for regulating the light power output of a laser diode operating under continuous conditions, in which an electric signal representative of said light power is compared with an electric reference signal corresponding to a reference power for elaborating an error signal, and the operating conditions of the laser diode are automatically modified as a function of said signal, characterized in that the heat flow extracted from the laser diode is controlled so as to cancel out the error signal while supplying the laser diode with constant electric current.

2. A device for regulating the light power output of a laser diode associated with an electric supply circuit, comprising a photodetector (6) arranged so as to supply an electric signal representative of an average value of said light power of the laser diode and a circuit associated with the photodetector for supplying an error signal representative of the difference between the light power and a reference power, as well as a control circuit for controlling the cooling means of the laser, characterized in that said control circuit is connected to receive the error signal and to control the cooling in a direction tending to cancel out the error signal and in that said electric supply circuit (12, 32) is delivering a constant current under stated operating conditions.

3. A device according to claim 2, characterized in that it comprises, in addition, a servo control branch (30) controlling the electric supply circuit (32) when the difference between the light power supplied by the laser diode (2) and the reference power exceeds a predetermined threshold value.

4. A device according to claim 2, characterized in that it further comprises a servo control branch (30) controlling the electric supply circuit (32) in response to the rapid variations of the optical output power of the laser.

5. A device according to claim 3 or 4, characterized in that said servo control branch comprises an input connected to the output of the circuit (8) associated with the detector and comprises an operational amplifier preceded by a threshold element (38) and/or a high pass filter (44).

# FIG.1

# FIG.2

# FIG.3

FIG.4

$\Delta T$

$t$

FIG.5

$\Delta I$

$t$

$P$

$T_0$  $T_1$  $T_2$

FIG.6

$I$

$I_{th}$

$P$

FIG.7

$I$

$I_k$

# FIG.8

# FIG.9

FIGs.10

A

B

C

D

E

7

# 0 138 871

## FIGs.11

A

B

C

D

## FIG.12

## FIG.13